# FASCICULE DE BREVET EUROPEEN

(11) **EP 1 056 214 B1**
(45) Date de publication et mention de la délivrance du brevet: **27.07.2005**
(21) Numéro de dépôt: 00110309.2
(22) Date de dépôt: 13.05.2000
(51) Int. Cl.: H04B 1/16, H03L 7/08, H03L 3/00

(54) **Dispositif à verrouillage de phase à consommation électrique réduite**
Phasenregelschleife mit reduzierten Leistungsverbrauch
Phase locked loop circuit with low power consumption

(30) Priorité: 28.05.1999 FR 9907019
(43) Date de publication de la demande: 29.11.2000
(73) Titulaire: STMicroelectronics SA, F-92120 Montrouge (FR)
(72) Inventeur: Sirito-Olivier, Philippe, 38120 Saint Egreve (FR); Dugas, Christophe, 38340 Voreppe (FR)
(74) Mandataire: Marchand, André

(56) Documents cités:
- EP-A- 0 829 967
- GB-A- 2 258 960
- GB-A- 2 290 899
- US-A- 5 606 739

## Description

La présente invention concerne un dispositif radio comprenant un oscillateur primaire, une boucle à verrouillage de phase excitée par un signal délivré par l'oscillateur primaire, et un circuit émetteur et/ou récepteur radio recevant un signal radiofréquence délivré par la boucle à verrouillage de phase.

De façon générale, les circuits émetteurs et/ou récepteurs radio nécessitent pour leur fonctionnement (détection de porteuse, modulation et démodulation) l'application d'un signal radiofréquence généré par un oscillateur. Cet oscillateur est par exemple du type à résonance, à multiplication de fréquence ou encore à synthèse de fréquence au moyen d'une boucle à verrouillage de phase.

Les oscillateurs pourvus d'une boucle à verrouillage de phase sont couramment utilisés dans les applications nécessitant plusieurs canaux de fréquences, car le passage d'un canal radio à un autre est alors obtenu par un simple changement du rang de division d'un diviseur de fréquence programmable agencé dans la boucle à verrouillage.

Par ailleurs, avec l'évolution des techniques d'intégration sur silicium des circuits émetteurs-récepteurs radio et la diminution de leur prix de revient, on a vu se développer diverses applications de ces circuits à la télétransmission de données fournies par des systèmes de mesure comme des capteurs ou des compteurs, ou encore à la commande à distance de systèmes d'actionnement.

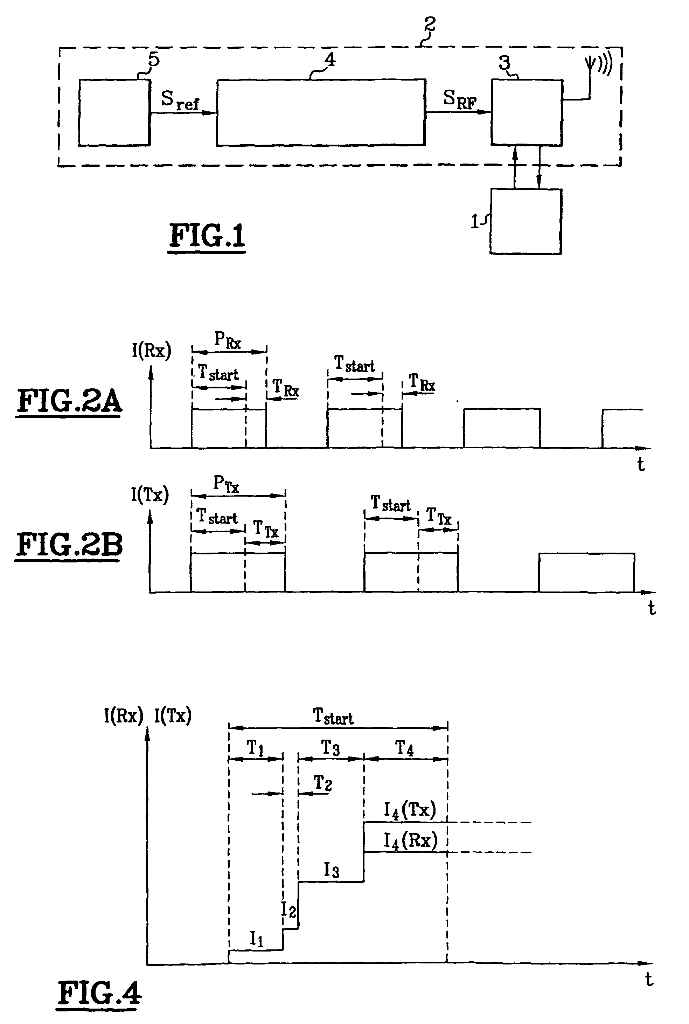

A titre d'exemple, la figure 1 représente schématiquement un compteur 1, par exemple un compteur de gaz, équipé d'un dispositif radio 2 pour transmettre par la voie hertzienne des données de comptage. Le dispositif radio 2 comprend un circuit émetteur-récepteur 3 recevant en entrée un signal radiofréquence S_{RF} délivré par une boucle à verrouillage de phase 4, elle-même étant excitée par un signal S_{ref} délivré par un oscillateur primaire 5.

Dans ce type d'application, le dispositif radio 2 est généralement autonome et comporte sa propre source d'alimentation électrique comme une pile ou une batterie. Pour préserver la durée de vie de la source d'alimentation, le dispositif radio 2 fonctionne par intermittence selon un protocole déterminé visant à réduire les périodes d'activité radio. Par exemple, ce protocole consiste à placer le dispositif 2 en mode réception pendant une fraction de seconde toutes les 10 secondes, de façon continuelle ou à certaines heures de la journée ou du mois. Quand une demande de transmission de données est reçue (télérelève du compteur), le dispositif bascule du mode réception au mode émission, envoie les données fournies par le compteur, puis revient à l'état de veille (stand-by). Si par contre aucun appel n'est détecté (absence de porteuse), le dispositif revient immédiatement à l'état de veille.

En pratique, les demandes de transmission de données sont rares et la consommation électrique moyenne du dispositif radio 2 est essentiellement déterminée par les nombreuses périodes d'écoute radio. La figure 2A représente la courbe du courant consommé par le dispositif 2 et montre que chaque période P_{Rx} d'écoute radio comprend une période Tₛₜₐᵣₜ de mise sous tension au cours de laquelle le dispositif 2 passe de l'état de veille à l'état actif, et une période T_{Rx} pendant laquelle le dispositif est effectivement opérationnel en mode réception. Le temps de démarrage Tₛₜₐᵣₜ est relativement long, de l'ordre de quelques millisecondes à quelques dizaines de millisecondes. Ce temps Tₛₜₐᵣₜ est déterminé notamment par le temps de démarrage de l'oscillateur primaire 5 auquel s'ajoute le temps de démarrage et de stabilisation de la boucle à verrouillage de phase 4 et, lorsque la boucle 4 est verrouillée, le temps de mise en service du circuit d'émission-réception 3. Par contre, le temps d'écoute T_{Rx} proprement dit est généralement très bref, puisque le dispositif revient immédiatement à l'état de veille quand la porteuse RF n'est pas détectée ou quand le message reçu ne nécessite pas de réponse.

Ainsi, il apparaît que le temps de démarrage Tₛₜₐᵣₜ a une influence non négligeable sur la consommation moyenne d'un dispositif radio fonctionnant de façon intermittente pendant des périodes de courte durée.

Comme illustré par la figure 2B, cet inconvénient se retrouve dans les applications où le dispositif radio ne fonctionne qu'en mode émission et envoie répétitivement les données fournies par le compteur 1, par exemple toutes les 10 secondes, sans savoir si ces données sont reçues par un opérateur. Ici, c'est la répétitivité des séquences d'émission qui garantit que les données seront accessibles au moment de la télérelève. Dans cette application comme dans la précédente, chaque période d'émission P_{Tx} comprend une période opérationnelle T_{Tx} précédée d'une période de mise en service Tₛₜₐᵣₜ ayant une influence non négligeable sur la consommation électrique.

Une solution classique pour pallier cet inconvénient consiste à améliorer les caractéristiques technologiques des circuits intégrés ayant une incidence sur leur consommation électrique et leur vitesse de commutation. Toutefois, le temps de stabilisation d'une boucle à verrouillage de phase dépend de divers autres paramètres, notamment des caractéristiques d'un filtre de boucle assurant la pureté spectrale du signal S_{RF}, et est d'autant plus long que la bande passante de ce filtre est étroite. Egalement, un oscillateur à quartz présente un temps de démarrage non négligeable déterminé par les propriétés piézoélectriques du quartz.

La présente invention vise à pallier cet inconvénient.

Plus particulièrement, la présente invention vise un dispositif radio du type précité à consommation électrique réduite.

Le document US-A-5 606 739 représente l'état de la technique le plus proche. Ce document décrit les caractéristiques du préambule de la revendication 1.

Cet objectif est atteint par la prévision d'un dispositif radio comprenant un oscillateur primaire, au moins une boucle à verrouillage de phase excitée par un signal délivré par l'oscillateur primaire et un circuit émetteur et/ou récepteur radio recevant en entrée un signal radiofréquence délivré par la boucle à verrouillage de phase, la boucle à verrouillage de phase comprenant un comparateur de phase, un oscillateur contrôlé en tension et des éléments de boucle, le dispositif radio comprenant des moyens pour mettre sous tension l'oscillateur primaire avant de mettre sous tension la boucle à verrouillage de phase.

Selon un mode de réalisation, les moyens de mise sous tension sont agencés pour mettre sous tension l'oscillateur contrôlé en tension avant de mettre sous tension d'autres éléments de la boucle à verrouillage de phase.

Selon un mode de réalisation, les moyens de mise sous tension comprennent des moyens de temporisation pour déterminer la durée entre la mise sous tension de l'oscillateur contrôlé en tension et la mise sous tension d'autres éléments de la boucle à verrouillage de phase.

Selon un mode de réalisation, les moyens de mise sous tension comprennent des moyens pour surveiller la sortie de l'oscillateur primaire et sont agencés pour mettre sous tension au moins un élément de la boucle à verrouillage de phase lorsque la sortie de l'oscillateur primaire délivre un signal supérieur à un seuil prédéterminé.

Selon un mode de réalisation, les moyens de mise sous tension sont agencés pour ne mettre sous tension le circuit émetteur et/ou récepteur radio qu'après la mise sous tension de tous les éléments de la boucle à verrouillage de phase.

Selon un mode de réalisation, les moyens de mise sous tension comprennent des moyens de détection du verrouillage de la boucle à verrouillage de phase et sont agencés pour mettre sous tension le circuit émetteur et/ou récepteur radio lorsque la boucle à verrouillage de phase est verrouillée.

Selon un mode de réalisation, les moyens de détection du verrouillage de la boucle à verrouillage de phase comprennent un comparateur à fenêtre recevant en entrée le signal de commande de l'oscillateur contrôlé en tension.

Selon un mode de réalisation, la boucle à verrouillage de phase comprend un diviseur de fréquence programmable permettant de modifier la fréquence du signal radiofréquence qu'elle délivre, et les moyens de mise sous tension sont agencés pour désactiver le circuit émetteur et/ou récepteur radio lorsque le rang de division du diviseur de fréquence est modifié, et remettre sous tension le circuit émetteur et/ou récepteur lorsque la boucle à verrouillage de phase est verrouillée sur une nouvelle fréquence.

La présente invention concerne également un dispositif, notamment capteur ou compteur d'une grandeurs physique, actionneur, radiotéléphone, comprenant un dispositif radio selon l'invention.

Ces objets, caractéristiques et avantages de la présente invention seront exposés plus en détail dans la description suivante d'un exemple de réalisation d'un dispositif électronique selon l'invention, faite à titre non limitatif en relation avec les figures suivantes parmi lesquelles :
- la figure 1 précédemment décrite représente schématiquement un compteur équipé d'un dispositif radio,
- les figures 2A, 2B sont des courbes représentant le courant consommé par un dispositif radio fonctionnant de façon intermittente en mode réception ou en mode émission,
- la figure 3 représente sous forme de blocs le schéma électrique d'un compteur comprenant un dispositif radio selon l'invention,
- la figure 4 est une courbe représentant le courant consommé par le dispositif radio selon l'invention.

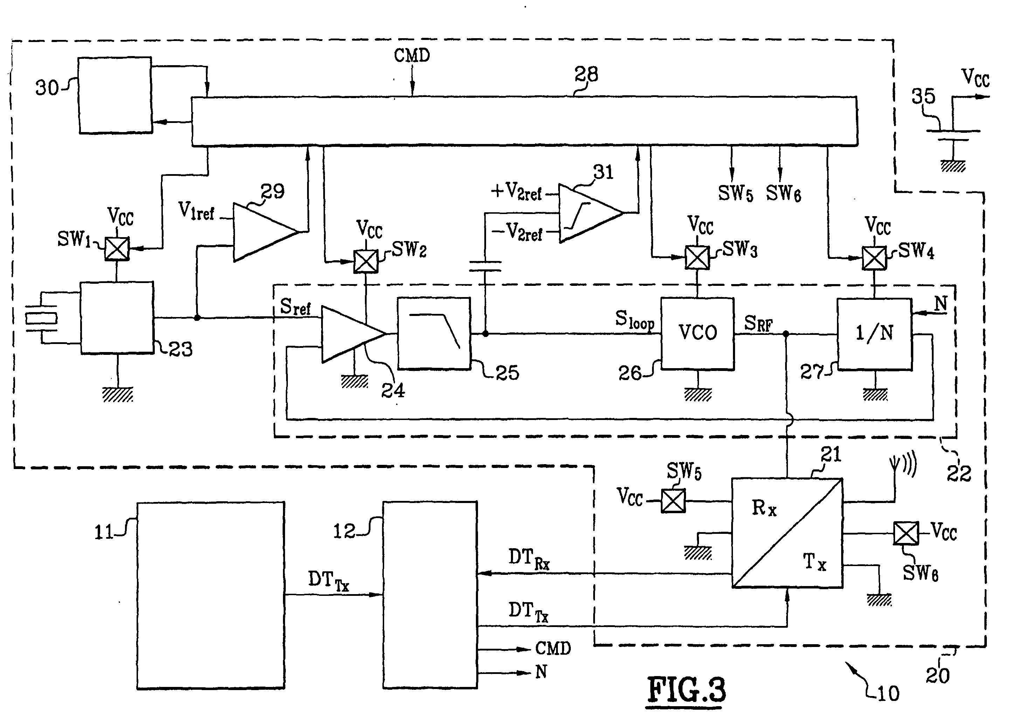

La figure 3 représente schématiquement un compteur 10 comprenant une unité 11 de détection et de comptage d'une grandeur physique, un microprocesseur 12, un dispositif radio 20 selon l'invention et une pile électrique 35. Le compteur 10 est par exemple un compteur de gaz, d'eau, d'électricité... La pile 35 délivre une tension Vcc d'alimentation du microprocesseur 12 et du dispositif radio 20.

Le dispositif radio 20 comprend un circuit émetteur-récepteur 21 comprenant un bloc émetteur Tx et un bloc récepteur Rx, une boucle à verrouillage de phase 22 et un oscillateur primaire 23. De façon classique, la boucle à verrouillage 22 comprend un comparateur de phase 24, un filtre de boucle 25 du type passe-bas, un oscillateur contrôlé en tension 26 (VCO) et un diviseur de fréquence programmable 27 de rang N contrôlé par le microprocesseur 12. Le comparateur de phase 24 reçoit sur une première entrée un signal de référence S_{ref} délivré par l'oscillateur primaire 23, et sur une autre entrée la sortie du diviseur 27. La sortie du comparateur 24 est appliquée à l'oscillateur 26 par l'intermédiaire du filtre 25. La sortie de l'oscillateur 26, appliquée à l'entrée du diviseur 27, délivre un signal radiofréquence S_{RF} d'une fréquence N fois supérieure à la fréquence du signal S_{ref}, qui est envoyé au circuit émetteur-récepteur 21.

Toujours de façon classique, le bloc Rx comprend des amplificateurs de réception, des mélangeurs et des démodulateurs (non représentés), et le bloc Tx comprend des modulateurs et des chaînes d'amplification. Les données DT_{Rx} (commandes) reçues par le bloc Rx sont fournies au microprocesseur 12 pour analyse et traitement, et les données de comptage DT_{Tx} délivrées par l'unité de comptage 11 sont lues par le microprocesseur 12 et appliquées au bloc Tx pour leur transmission par la voie hertzienne.

Le compteur 10 fonctionne par intermittence d'une manière déjà décrite en relation avec les figures 2A, 2B, à savoir selon des phases d'écoute P_{Rx} permettant de détecter une demande d'envoi des données DT_{Tx} ou, au choix selon l'application, selon des phases P_{Tx} d'envoi systématique des données DT_{Tx}. Quel que soit le mode de fonctionnement retenu, chaque phase comprend une période de démarrage Tₛₜₐᵣₜ suivie d'une période opérationnelle T_{Rx} ou T_{Tx}.

Dans l'art antérieur, le démarrage du dispositif radio 20 est effectué en mettant simultanément sous tension tous ses éléments constitutifs, à savoir l'oscillateur primaire 23, la boucle 22 et les éléments du bloc Tx ou du bloc Rx. Selon l'invention, on considère au contraire que l'alimentation simultanée de tous ces éléments conduit à une perte d'énergie électrique inutile ayant une incidence importante sur la consommation moyenne.

Ainsi, selon l'invention, la tension d'alimentation Vcc est appliquée aux divers éléments du circuit radio 20 de façon séquentielle et progressive au moyen d'interrupteurs SW1 à SW6 pilotés par un séquenceur 28. Plus particulièrement, la tension Vcc est appliquée à l'oscillateur primaire 23 par l'intermédiaire de l'interrupteur SW1, au comparateur 24 par l'intermédiaire de l'interrupteur SW2, à l'oscillateur 26 par l'intermédiaire de l'interrupteur SW3, au diviseur 27 par l'intermédiaire de l'interrupteur SW4, et respectivement aux blocs Rx, Tx par l'intermédiaire des interrupteurs SW5, SW6.

Le tableau 1 ci-après décrit le fonctionnement du séquenceur 28. La mise sous tension progressive du dispositif radio 20, à partir d'une étape E0 correspondant à l'état de veille (stand-by), s'effectue ici en trois étapes intermédiaires E1 à E3 suivies d'une étape finale E4 au cours de laquelle le bloc Rx ou le bloc Tx est mis sous tension.

**Tableau 1**

| **Etapes** | **Durée** | **Courant consommé** | **Eléments mis sous tension** |
|---|---|---|---|
| E0 | - | - | Aucun (stand-by) |
| E1 | T1 | I1 | Oscillateur primaire 23 |
| E2 | T2 | I2 | Oscillateur primaire 23 |
| | | | + oscillateur VCO 26 |
| E3 | T3 | I3 | Oscillateur primaire 23 |
| | | | + oscillateur VCO 26 |
| | | | + comparateur de phase 24 |
| | | | + diviseur 27 |
| | | | + autres éléments éventuels de la boucle 22 |
| E4 | T4 | I4 | Oscillateur primaire 23 |
| | | | + oscillateur VCO 26 |
| | | | + comparateur de phase 24 |
| | | | + diviseur 27 |
| | | | + autres éléments éventuels de la boucle 22 |
| | | | + bloc Rx ou bloc Tx |

De préférence, la durée T1 de l'étape E1 est choisie pour correspondre au temps nécessaire à la stabilisation de l'oscillateur primaire 23. Comme illustré sur la figure 3, on prévoit à cet effet un comparateur 29 recevant en entrée la sortie de l'oscillateur 23 et une tension de référence V_{1ref}, dont la sortie est appliquée au séquenceur 28. Ainsi, lorsque le signal S_{ref} présente une tension supérieure à V_{ref}, la sortie du comparateur 29 change de valeur et le séquenceur 28 passe de l'étape E1 à l'étape E2.

La durée T2 de l'étape E2 est de préférence déterminée par un compteur 30 de type "timer", connecté au séquenceur 28, et est choisie en fonction d'observations expérimentales pour correspondre au temps de stabilisation de l'oscillateur VCO 26.

Enfin, la durée T3 de l'étape E3 est de préférence déterminée par un moyen de détection du verrouillage de la boucle 22. Ce moyen est par exemple un comparateur à fenêtre 31 présentant un temps de relaxation τ non nul, dont la sortie est appliquée au séquenceur 28. Le comparateur 31 reçoit en entrée deux tensions de référence +V_{2ref}, -V_{2ref} ainsi que le signal Sloop de commande de l'oscillateur 26, prélevé à la sortie du filtre de boucle 25 par l'intermédiaire d'une capacité. Quand la boucle 22 n'est pas verrouillée, le signal Sloop oscille au-delà des seuils +V_{2ref}, -V_{2ref} et la sortie du comparateur 31 est à l'état haut. Lorsque le signal Sloop se stabilise à l'intérieur de la fenêtre +V_{2ref}, -V_{2ref}, la sortie du comparateur 31 repasse à l'état bas après que le temps de relaxation τ est écoulé.

Pour fixer les idées sur les avantages de la présente invention, le tableau 2 ci-après décrit des résultats expérimentaux obtenus par la demanderesse avec un dispositif radio 20 intégré sur silicium, pour passer de l'état de veille au mode réception Rx (bloc Tx non activé). Dans l'art antérieur, avec le même circuit intégré, le passage de l'état de veille au mode Rx nécessite la même durée de 13,64 ms et s'effectue avec le courant maximal I4 de 11,00 mA, ce qui correspond à une quantité d'électricité de 150,040 µC. Ainsi, ici, la présente invention permet de diminuer de 55% la consommation électrique pendant la phase de démarrage.

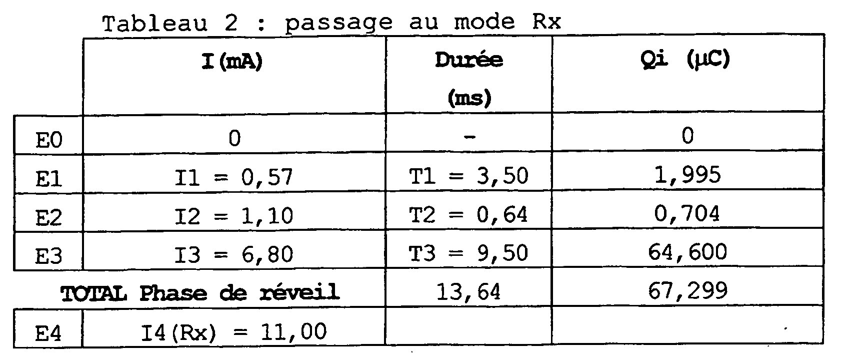

Par ailleurs, le tableau 3 ci-après décrit des résultats expérimentaux obtenus lors du passage de l'état de veille au mode émission Tx (circuit Rx non activé). Dans l'art antérieur, le passage de l'état de veille au mode Tx en 20,14 ms avec un courant maximal I4 de 18,00 mA correspond à une quantité d'électricité de 362,520 µC. Ainsi, ici, la présente invention permet de diminuer de 69% la consommation électrique pendant la phase de démarrage.

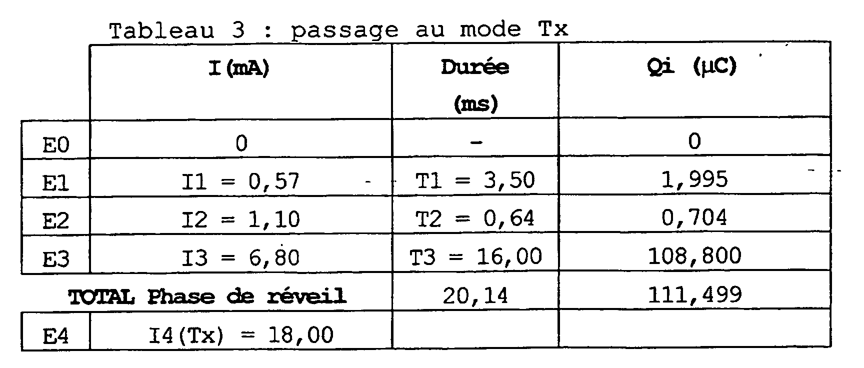

Pour résumer ce qui précède, la figure 4 représente la courbe du courant de démarrage I(Rx) ou I(Tx)en mode Rx ou Tx conformément aux valeurs données par les tableaux 2 et 3. On voit que cette courbe présente une forme en marche d'escalier, qui atteste d'une consommation moindre que les courbes en forme de créneaux des figures 2A et 2B.

Selon un autre aspect de l'invention, on optimise également la consommation électrique du dispositif 20 lors d'un changement de canal radio, pouvant intervenir en mode réception Rx, en mode émission Tx ou lors d'un passage du mode réception Rx au mode émission Tx. En effet, après une modification du rang N du diviseur 27 par le microprocesseur 12, la boucle 22 met un certain temps à se verrouiller sur la nouvelle fréquence. Pendant ce temps, le bloc Rx ou Tx opérationnel consomme inutilement du courant. Aussi, la présente invention propose que le bloc Rx ou Tx concerné ne soit plus alimenté électriquement par le séquenceur 28 pendant cette période, jusqu'à ce que la sortie du détecteur de verrouillage 31 repasse à l'état bas. En pratique, pour gérer ces diverses séquences et possibilités de mise sous tension ou de mise hors tension des éléments du dispositif 20, le séquenceur 28 peut recevoir du microprocesseur 12 des commandes CMD, codées par exemple sur 3 bits, indiquant le type d'opération à effectuer, notamment le passage de l'état de veille au mode Rx, le passage de l'état de veille au mode Tx, l'extinction temporaire du bloc Rx (changement de canal en mode Rx), l'extinction provisoire du bloc Tx (changement de canal en mode Tx), ou l'extinction du bloc Rx et la mise sous tension du bloc Tx après verrouillage (changement de canal avec passage du mode Rx au mode Tx).

Il va de soi que la présente invention est susceptible de diverses variantes et modes de réalisation. Il appartient notamment à l'homme de l'art de prévoir, selon les caractéristiques et la complexité du dispositif radio utilisé, un nombre plus ou moins grand d'étapes de mise sous tension. Par ailleurs, il sera noté que la présente invention concerne également les dispositifs radio comportant plusieurs boucles à verrouillage de phase imbriquées. Dans ce cas, il est à la portée de l'homme de l'art de déterminer, après une observation des cycles de démarrage des divers éléments des boucles imbriquées, les dépendances fonctionnelles apparaissant entre ces éléments et d'en déduire une séquence de démarrage de ces éléments qui soit optimale en termes de consommation électrique.

Enfin, il est bien évident que la présente invention est applicable à tout dispositif connu, notamment aux capteurs et aux actionneurs comportant un dispositif embarqué de communication radio, dès lors qu'une diminution de la consommation électrique moyenne du dispositif radio est souhaitable. La présente invention est également applicable aux radiotéléphones présentant un mode réception de type intermittent (comprenant par exemple 40 ms en mode réception et 80 ms en mode veille) pour prolonger la durée de vie de leurs batteries.

## Revendications

1. Dispositif radio (20) comprenant un oscillateur primaire (23), au moins une boucle à verrouillage de phase (22) excitée par un signal (S_{ref}) délivré par l'oscillateur primaire et un circuit (21, Rx, Tx) émetteur et/ou récepteur radio recevant en entrée un signal radiofréquence (S_{RF}) délivré par la boucle à verrouillage de phase, la boucle à verrouillage de phase (22) comprenant un comparateur de phase (24), un oscillateur contrôlé en tension (26) et des éléments de boucle (25, 27), **caractérisé en ce qu'**il comprend des moyens (28-31, SW1-SW6) pour mettre sous tension l'oscillateur primaire (23) avant de mettre sous tension la boucle à verrouillage de phase (22).

2. Dispositif selon la revendication 1, **caractérisé en ce que** les moyens de mise sous tension (28-31, SW1-SW6) sont agencés pour mettre sous tension l'oscillateur contrôlé en tension (26) avant de mettre sous tension d'autres éléments (27) de la boucle à verrouillage de phase.

3. Dispositif selon la revendication 2, dans lequel les moyens de mise sous tension comprennent des moyens (30) de temporisation pour déterminer la durée (T2) entre la mise sous tension de l'oscillateur contrôlé en tension (26) et la mise sous tension d'autres éléments (27) de la boucle à verrouillage de phase.

4. Dispositif selon l'une des revendications 1 à 3, dans lequel les moyens de mise sous tension comprennent des moyens (29) pour surveiller la sortie de l'oscillateur primaire (23) et sont agencés pour mettre sous tension au moins un élément (26) de la boucle à verrouillage de phase lorsque la sortie de l'oscillateur primaire délivre un signal (S_{ref}) supérieur à un seuil prédéterminé (V_{1ref}).

5. Dispositif selon l'une des revendications 1 à 4, dans lequel les moyens de mise sous tension sont agencés pour ne mettre sous tension le circuit émetteur et/ou récepteur radio (21, Rx, Tx) qu'après la mise sous tension de tous les éléments de la boucle à verrouillage de phase (22).

6. Dispositif selon l'une des revendications 1 à 5, dans lequel les moyens de mise sous tension comprennent des moyens (31) de détection du verrouillage de la boucle à verrouillage de phase (22) et sont agencés pour mettre sous tension le circuit émetteur et/ou récepteur radio (21, Rx, Tx) lorsque la boucle à verrouillage de phase est verrouillée.

7. Dispositif selon la revendication 6, dans lequel les moyens (31) de détection du verrouillage de la boucle à verrouillage de phase (22) comprennent un comparateur à fenêtre recevant en entrée le signal de commande (Sₗₒₒₚ) de l'oscillateur contrôlé en tension (26).

8. Dispositif selon l'une des revendications 1 à 7, dans lequel la boucle à verrouillage de phase comprend un diviseur de fréquence programmable (27) permettant de modifier la fréquence du signal radiofréquence (S_{RF}) qu'elle délivre, et les moyens de mise sous tension (28-31, SW1-SW6) sont agencés pour désactiver le circuit émetteur et/ou récepteur radio lorsque le rang de division du diviseur de fréquence est modifié, et remettre sous tension le circuit émetteur et/ou récepteur lorsque la boucle à verrouillage de phase est verrouillée sur une nouvelle fréquence.

9. Dispositif, notamment capteur ou compteur (10) d'une grandeur physique, actionneur, radiotéléphone, comprenant un dispositif radio selon l'une des revendications 1 à 8.

## Patentansprüche

1. Funkvorrichtung (20), umfassend einen Primäroszillator (23), mindestens eine Schleife mit Phasenverriegelung (22), die von einem Signal (S_{ref}) erregt wird, das von dem Primäroszillator geliefert wird, und eine Funksende- und/oder Empfangsschaltung (21, Rx, Tx), die am Eingang ein Funkfrequenzsignal (S_{RF}) empfängt, das von der Schleife mit Phasenverriegelung geliefert wird, wobei die Schleife mit Phasenverriegelung (22) einen Phasenkomparator (24) umfasst, einen spannungsgesteuerten Oszillator (26) und Schleifenelemente (25, 27), **dadurch gekennzeichnet, dass** sie Mittel (28-31, SW1-SW6) umfasst, um den Primäroszillator (23) unter Spannung zu setzen, bevor die Schleife mit Phasenverriegelung (22) unter Spannung gesetzt wird.

2. Vorrichtung nach Anspruch 1, **dadurch gekennzeichnet, dass** die Mittel zum Unterspannungsetzen (28-31, SW1-SW6) eingerichtet sind, um den spannungsgesteuerten (26) Oszillator unter Spannung zu setzen, bevor die anderen Elemente (27) der Schleife mit Phasenverriegelung (22) unter Spannung gesetzt werden.

3. Vorrichtung nach Anspruch 2, bei welcher die Mittel zum Unterspannungsetzen Mittel (30) zum Verzögern umfassen, um die Dauer (T2) zwischen dem Unterspannungsetzen des spannungsgesteuerten Oszillators (26) und dem Unterspannungsetzen anderer Elemente (27) der Schleife mit Phasenverriegelung zu bestimmen.

4. Vorrichtung nach einem der Ansprüche 1 bis 3, bei welcher die Mittel zum Unterspannungsetzen Mittel (29) umfassen, um den Ausgang des Primäroszillators (23) zu überwachen, und die eingerichtet sind, um zumindest ein Element (26) der Schleife mit Phasenverriegelung unter Spannung zu setzen, wenn der Ausgang des Primäroszillators ein Signal (S_{ref}) liefert, das größer ist als ein vorausbestimmter Schwellenwert (V_{1ref}).

5. Vorrichtung nach einem der Ansprüche 1 bis 4, bei welcher die Mittel zum Unterspannungsetzen eingerichtet sind, um die Funksende- und/oder Empfangsschaltung (21, Rx, Tx) erst nach dem Unterspannungsetzen aller Elemente der Schleife mit Phasenverrieglung (22) unter Spannung zu setzen.

6. Vorrichtung nach einem der Ansprüche 1 bis 5, bei welcher die Mittel zum Unterspannungsetzen Mittel (31) zum Erfassen des Verriegelns der Schleife mit Phasenverriegelung (22) umfassen und eingerichtet sind, um die Funksende- und/oder Empfangsschaltung (21, Rx, Tx) unter Spannung zu setzen, wenn die Schleife mit Phasenverriegelung verriegelt ist.

7. Vorrichtung nach Anspruch 6, bei welcher die Mittel (31) zum Erfassen der Verriegelung der Schleife mit Phasenverriegelung (22) einen Komparator mit Fenster umfassen, der am Eingang das Steuersignal (Sₗₒₒₚ) des spannungsgesteuerten Oszillators (26) empfängt.

8. Vorrichtung nach einem der Ansprüche 1 bis 7, bei welcher die Schleife mit Phasenverriegelung einen programmierbaren Frequenzteiler (27) umfasst, der es erlaubt, die Frequenz des Funksignals (S_{RF}), welche sie liefert, zu modifizieren, und bei welcher die Mittel zum Unterspannungsetzen (28-31, SW1-SW6) eingerichtet sind, um die Funksende- und/oder Empfangsschaltung zu deaktivieren, wenn der Teilerrang des Frequenzteilers modifiziert wird, und die Funksende- und/oder Empfangsschaltung wieder unter Spannung zu setzen, wenn die Schleifen mit Phasenverriegelung auf einer neuen Frequenz verriegelt ist.

9. Vorrichtung, insbesondere Sender oder Zähler (10) mit einer physikalischen Größe, Stellglied, Funktelefon, die eine Funkvorrichtung nach einem der Ansprüche 1 bis 8 umfasst.

## Claims

1. Radio device (20) comprising a primary oscillator (23), at least one phase locked loop (22) driven by a signal (S_{ref}) provided by the primary oscillator and a radio emitter and/or receiver circuit (21, Rx, Tx) receiving as an input a radiofrequency signal (S_{RF}) provided by the phase locked loop, the phase locked loop (22) comprising a phase comparator (24), a voltage controlled oscillator (26) and loop elements (25, 27), **characterised in that** it comprises means (28-31, SW1-SW6) for powering-on the primary oscillator (23) before powering-on the phase locked loop (22).

2. Device according to claim 1, **characterised in that** the powering-on means (28-31, SW1-SW6) are arranged to power-on the voltage controlled oscillator (26) before powering-on other elements (27) of the phase locked loop.

3. Device according to claim 2, wherein the powering-on means comprise temporisation means (30) for determining the duration (T2) between the powering-on of the voltage controlled oscillator (26) and the powering-on of other elements (27) of the phase locked loop.

4. Device according to one of the claims 1 to 3, wherein the powering-on means comprise means (29) for monitoring the output of the primary oscillator (23) and are arranged to power-on at least one element (26) of the phase locked loop when the output of the primary oscillator delivers a signal (S_{ref}) above a predetermined threshold (V_{1ref}).

5. Device according to one of the claims 1 to 4, wherein the powering-on means are arranged for powering-on the radio emitter and/or receiver circuit (21, Rx, Tx) only after powering-on all the elements of the phase locked loop (22).

6. Device according to one of the claims 1 to 5, wherein the powering-on means comprise means (31) for detecting the locking of the phase locked loop (22) and are arranged to power-on the radio emitter and/or receiver circuit (21, Rx, Tx) when the phase locked loop is locked.

7. Device according to claim 6, wherein the means (31) for detecting the locking of the phase locked loop (22) comprise a window comparator receiving as an input the control signal (Sₗₒₒₚ) of the voltage controlled oscillator (26).

8. Device according to one of the claims 1 to 7, wherein the phase locked loop comprises a programmable frequency divider (27) enabling the change of the frequency of the radiofrequency signal (S_{RF}) that it delivers, and the powering-on means (28-31, SW1-SW6) are arranged to disable the radio emitter and/or receiver circuit when the division range of the frequency divider is changed, and power-on again the emitter and/or receiver circuit when the phase locked loop is locked upon a new frequency.

9. Device, in particular a sensor or a meter (10) of a physical magnitude, an actuator, a radiotelephone, comprising a radio device according to one of the claims 1 to 8.
